# EUROPEAN PATENT APPLICATION

(11) **EP 4 525 000 A1**
(43) Date of publication of application: **19.03.2025**
(21) Application number: 23803786.5
(22) Date of filing: 08.05.2023
(51) Int. Cl.: H01B 5/16, H01B 3/30, H01B 13/00, G03F 7/20, C08L 15/00

(54) **STRETCHABLE ANISOTROPIC CONDUCTIVE FILM, METHOD FOR MANUFACTURING SAME, AND STRETCHABLE ELECTRONIC DEVICE COMPRISING SAME**

(30) Priority: 09.05.2022 KR 20220056785; 04.05.2023 KR 20230058553
(71) Applicant: Midas H&T Inc., Pohang-si Gyeongsangbuk-do 37673 (KR); Postech Academy-Industry Foundation, Gyeongsangbuk-do, 37673 (KR)
(72) Inventor: JEONG, Un Yong, Pohang-Si Gyeongsangbuk-do 37673 (KR); LIM, Ig Hyun, Pohang-Si Gyeongsangbuk-do 37673 (KR); KONG, Min Sik, Pohang-Si Gyeongsangbuk-do 37673 (KR); CHANG, Se Yun, Gwacheon-si Gyeonggi-do 13818 (KR); PARK, Hye Ji, Pohang-si Gyeongsangbuk-do 37761 (KR)
(74) Representative: Carpmaels & Ransford LLP
(86) International application number: PCT/KR2023/006220
(87) International publication number: WO 2023/219363

(57) **Abstract**

The present invention relates to a stretchable anisotropic conductive film, a method for manufacturing same, and a stretchable electronic device comprising same. The stretchable anisotropic conductive film according to an embodiment of the invention comprises: a patterned stretchable polymer; and liquid metal which fills the patterned portion of the stretchable polymer.

## Description

### TECHNICAL FIELD

The present disclosure relates to a stretchable anisotropic conductive film, a method of manufacturing the same, and a stretchable electronic device including the same.

### BACKGROUND ART

As stretchable electronic devices, which are highly utilized in fields such as electronic skin and healthcare, have been actively studied, electrical bonding that stably connects stretchable devices and circuits is also becoming important. **In** addition, anisotropic conductive films (ACFs) with highly regular arrangements are essential for electrical connections between increasingly fine devices and circuits.

However, existing ACFs had unstable connections when stretched due to differences in elastic moduli between components of devices and had limitations in regular arrangements at fine spacings or large-scale.

Since hard microparticles or solder balls for conductivity are included in an ACF according to a related art, when the ACF is used as a stretchable anisotropic conductive film (S-ACF) and stretched, only a stretchable polymer stretches and conductive balls do not stretch, which may cause issues such as detachment of the conductive balls from a film or electrical disconnection.

In addition, there are limitations in that it has low resolution and reliability due to a random arrangement of conductive particles or that only a portion pressed by a protruding electrode has anisotropic conductivity.

The above description has been possessed or acquired by the inventor(s) in the course of conceiving the present disclosure and is not necessarily an art publicly known before the present application is filed.

### DISCLOSURE OF THE INVENTION

### TECHNICAL GOALS

The present disclosure is to solve the above-described problems, and an aspect of the present disclosure is to provide a stretchable anisotropic conductive film having a large area, a high stretchability, and an excellent conductivity, a method of manufacturing the same, and a stretchable electronic device including the same.

However, goals to be achieved by the present disclosure are not limited to those described above, and other goals not mentioned above can be clearly understood by one of ordinary skill in the art from the following description.

### TECHNICAL SOLUTIONS

A stretchable anisotropic conductive film according to an embodiment of the present disclosure includes: a patterned stretchable polymer; and a liquid metal filled in a patterned portion of the stretchable polymer.

In an embodiment, the liquid metal may be configured to allow current to pass through both sides of the anisotropic conductive film.

In an embodiment, the liquid metal may include at least one selected from a group consisting of gallium (Ga), indium (In), tin (Sn), mercury (Hg), lead (Pb), bismuth (Bi), cadmium (Cd), an eutectic gallium-indium alloy (EGaIn), an eutectic gallium-indium-tin alloy (Galinstan), gallium-indium (Ga/In), gallium/lead (Ga/Pb), gallium/cadmium (Ga/Cd), gallium/zinc (Ga/Zn), gallium/tin (Ga/Sn), gallium/bismuth (Ga/Bi), gallium/thallium (Ga/Tl), tin/silver (Sn/Ag), tin/gold (Sn/Au), tin/copper (Sn/Cu), tin/nickel (Sn/Ni), lead/antimony (Pb/Sb), lead/gold (Pb/Au), and lead/cadmium (Pb/Cd).

In an embodiment, the liquid metal may be in an amount of 10% by weight (wt%) to 80 wt% in the stretchable anisotropic conductive film.

In an embodiment, solid particles dispersed in the liquid metal may be further included.

In an embodiment, the solid particles may further include at least one selected from a group consisting of metal particles, metal oxide particles, and semiconductor oxide particles.

In an embodiment, the solid particles may have a core-shell structure.

In an embodiment, the metal particles may include at least one selected from a group consisting of copper (Cu), gold (Au), platinum (Pt), silver (Ag), iron (Fe), cobalt (Co), nickel (Ni), aluminum (Al), chromium (Cr), tungsten (W), molybdenum (Mo), and titanium (Ti).

In an embodiment, the metal oxide particles or semiconductor oxide particles may include at least one selected from a group consisting of SiO₂, Fe₂O₃, Fe₃O₄, BiVO₄, Bi₂WO₄, TiO₂, SrTiO₃, ZnO, CuO, Cu₂O, NiO, SnO₂, CoO, In₂O₃, WO₃, MgO, CaO, La₂O₃, Nd₂O₃, Y₂O₃, CeO₂, PbO, ZrO₂, Co₃O₄, and Al₂O₃.

In an embodiment, a volume ratio of the liquid metal : the solid particles may be in a range of 99 : 1 to 70 : 30.

In an embodiment, the stretchable polymer may include at least one selected from a group consisting of polydimethylsiloxane (PDMS), styrene-ethylene/butylene-styrene triblock copolymer (SEBS), styrene-ethylene/butylene-styrene-graft-maleic anhydride copolymer (SEBS-g-MA), polyethylene-graft-maleic anhydride (PE-g-MA), polypropylene-graft-maleic anhydride copolymer (SEBS-g-MA), polyethylene-graft-maleic anhydride (PE-g-MA), polypropylene-graft-maleic anhydride (PP-g-MA), polyethylene-graft-acrylic acid (PE-g-AA), poly-propylene-graft-acrylic acid (PP-g-AA), polyurethane (PU), polyethylene terephthalate (PET), polyethylene sulfone (PES), polymethacrylate (PMA), polyethylene naphthalate (PEN), polycarbonate (PC), polymethyl methacrylate (PMMA), polyimide (PI), polypropylene (PP), ethylene vinyl acetate (EVA), amorphous polyethylene terephthalate (APET), polypropylene terephthalate (PPT), polyethylene terephthalate glycerol (PETG), polycyclohexylene dimethylene terephthalate (PCTG), modified triacetyl cellulose (TAC), cyclo olefin polymer (COP), cyclo olefin copolymer (COC), dicyclopentadiene polymer (DCPD), cyclopentadiene polymer (CPD), polyarylate (PAR), polyether imide (PEI), a silicon resin, a fluorine resin, and a modified epoxy resin.

A method of manufacturing a stretchable anisotropic conductive film according to another embodiment of the present disclosure includes: a step of patterning a photoresist on a substrate; a step of surface-treating the substrate on which the photoresist is patterned; a step of applying a stretchable polymer onto the surface-treated substrate; a step of thermally curing the applied stretchable polymer; a step of removing the patterned photoresist; a step of removing the substrate; and a step of filling a space formed by removing the photoresist with a liquid metal.

In an embodiment, the surface-treating may be surface-treating the substrate using O₂ plasma, a silane-based material, or both.

In an embodiment, the silane-based material may include at least one selected from a group consisting of fluorodecyltrichlorosilane (FDTS), methacryloxypropyltrimethoxysilane (MPTMS), undecenyltrichlorosilane (UTS), vinyl-trichlorosilane (VTS), decyltrichlorosilane (DTS), octadecyltrichlorosilane (OTS), dimethyldichlorosilane (DDMS), dodecenyltrichlorosilane (DDTS), fluoro-tetrahydrooctyltrimethylchlorosilane (FOTS), perfluorooctyldimethylchlorosilane, aminopropylmethoxysilane (APTMS), chlorosilane, fluorosilane, methoxy silane, alkylsilane, and aminosilane.

In an embodiment, after the step of filling the space formed by removing the photoresist with the liquid metal, a step of adding solid particles to the liquid metal may be further included.

A stretchable electronic device according to another embodiment of the present disclosure includes the stretchable anisotropic conductive film according to an embodiment of the present disclosure or a stretchable anisotropic conductive film manufactured by the method of manufacturing the stretchable anisotropic conductive film according to another embodiment of the present disclosure.

In an embodiment, the stretchable electronic device may include at least one selected from a group consisting of a flexible display, a stretchable display, a semiconductor test socket, a sensor, and an electronic skin.

### EFFECTS OF THE INVENTION

A stretchable anisotropic conductive film according to an embodiment of the present disclosure may have a changeable shape and have a high anisotropic conductivity at a metal level (> 10⁶ S/m) by including a stretchable and conductive liquid metal that is in a liquid state at room temperature.

A method of manufacturing a stretchable anisotropic conductive film according to an embodiment of the present disclosure may be based on a liquid metal printing process, to achieve process simplicity, uniformity, large-area expansion, and economic feasibility.

A stretchable electronic device according to an embodiment of the present disclosure may be applicable to various flexible electronic devices or wearable displays by including a stretchable anisotropic conductive film according to an embodiment of the present disclosure.

### BRIEF DESCRIPTION OF THE DRAWINGS

FIG. 1A is a diagram schematically illustrating an example of a stretchable anisotropic conductive film according to an embodiment of the present disclosure.
FIG. 1B is a diagram schematically illustrating another example of a stretchable anisotropic conductive film according to an embodiment of the present disclosure.
FIG. 2A is a diagram illustrating a transformation of an anisotropic conductive film using solid conductive balls according to a related art, and FIG. 2B is a diagram illustrating a transformation of a stretchable anisotropic conductive film using a liquid metal according to the present disclosure.
FIGS. 3A to 3G are diagrams illustrating a method of manufacturing a stretchable anisotropic conductive film according to an embodiment of the present disclosure.
FIG. 4 illustrates images of a patterned surface of a polymer film through a photolithography process-based stamping process.

### BEST MODE FOR CARRYING OUT THE INVENTION

Hereinafter, embodiments will be described in detail with reference to the accompanying drawings. However, various alterations and modifications may be made to the embodiments, and the embodiments are not meant to be limited by the descriptions of the present disclosure. The embodiments should be understood to include all changes, equivalents, and replacements within the idea and the technical scope of the disclosure.

The terminology used herein is for the purpose of describing particular embodiments only and is not intended to be limiting. The singular forms "a," "an," and "the" are intended to include the plural forms as well, unless the context clearly indicates otherwise. It will be further understood that the terms "comprises/comprising" and/or "includes/including" when used herein, specify the presence of stated features, integers, steps, operations, elements, and/or components, but do not preclude the presence or addition of one or more other features, integers, steps, operations, elements, components and/or groups thereof.

Unless otherwise defined, all terms including technical and scientific terms used herein have the same meaning as commonly understood by one of ordinary skill in the art to which the embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

In addition, when describing the embodiments with reference to the accompanying drawings, like reference numerals refer to like components and a repeated description related thereto will be omitted. In the description of embodiments, detailed description of well-known related structures or functions will be omitted when it is deemed that such description will cause ambiguous interpretation of the present disclosure.

Furthermore, terms such as first, second, A, B, (a), (b), and the like may be used to describe components of the embodiments. Each of these terms is not used to define an essence, order or sequence of a corresponding component but used merely to distinguish the corresponding component from other component(s).

A component, which has the same common function as a component included in any one embodiment, will be described by using the same name in other embodiments. Unless disclosed to the contrary, the description of any one embodiment may be applied to other embodiments, and the specific description of the repeated configuration will be omitted.

Hereinafter, a stretchable anisotropic conductive film of the present disclosure, a method of manufacturing the same, and a stretchable electronic device including the same will be described in detail with reference to embodiments and drawings. However, the present disclosure is not limited to the embodiments and drawings.

A stretchable anisotropic conductive film according to an embodiment of the present disclosure includes: a patterned stretchable polymer; and a liquid metal filled in a patterned portion of the stretchable polymer.

The stretchable anisotropic conductive film according to an embodiment of the present disclosure may have a changeable shape and have a high anisotropic conductivity at a metal level (> 10⁶ S/m) by including a stretchable and conductive liquid metal that is in a liquid state at room temperature. Thus, the stretchable anisotropic conductive film may be applicable to various flexible electronic devices or wearable displays.

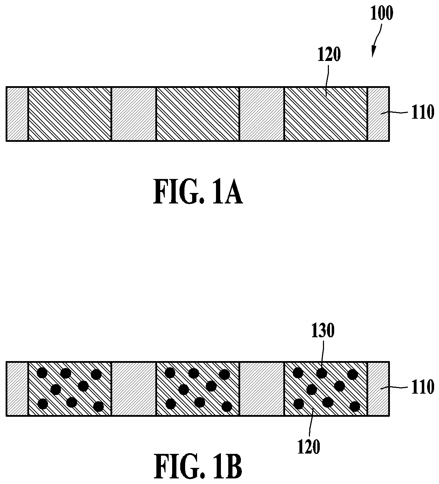

FIG. 1A is a diagram schematically illustrating an example of a stretchable anisotropic conductive film according to an embodiment of the present disclosure.

Referring to FIG. 1A, a stretchable anisotropic conductive film 100 according to an embodiment of the present disclosure includes a patterned stretchable polymer 110, and a liquid metal 120.

Although a material of the stretchable polymer 110 is not particularly limited if it is possible to stably support the liquid metal 120, the stretchable polymer 110 may be formed of, for example, a material having a flexibility, stretchability, or foldable and/or rollable characteristics.

A pattern width of the stretchable polymer 110 may change.

The stretchable polymer 110 may be patterned into a predetermined shape, or may be in the form of a through-hole punched or perforated by a pressure or laser.

In an embodiment, the liquid metal 120 may remain in a liquid state at room temperature and have a predetermined shape due to a surface tension and an interfacial tension between the liquid metal 120 and the stretchable polymer 110.

In an embodiment, by the liquid metal 120, current may anisotropically, that is, vertically pass through the anisotropic conductive film 100.

In an embodiment, the liquid metal may include at least one selected from a group consisting of gallium (Ga), indium (In), tin (Sn), mercury (Hg), lead (Pb), bismuth (Bi), cadmium (Cd), an eutectic gallium-indium alloy (EGaIn), an eutectic gallium-indium-tin alloy (Galinstan), gallium-indium (Ga/In), gallium/lead (Ga/Pb), gallium/cadmium (Ga/Cd), gallium/zinc (Ga/Zn), gallium/tin (Ga/Sn), gallium/bismuth (Ga/Bi), gallium/thallium (Ga/Tl), tin/silver (Sn/Ag), tin/gold (Sn/Au), tin/copper (Sn/Cu), tin/nickel (Sn/Ni), lead/antimony (Pb/Sb), lead/gold (Pb/Au), and lead/cadmium (Pb/Cd).

Desirably, the liquid metal may include gallium (Ga).

In an embodiment, the liquid metal 120 may be in an amount of 10% by weight (wt%) to 80 wt%; 10 wt% to 50 wt%; 10 wt% to 30 wt%; 10 wt% to 20 wt%; 30 wt% to 80 wt%; 30 wt% to 50 wt%; or 50 wt% to 80 wt% in the stretchable anisotropic conductive film 100.

If the amount of the liquid metal in the stretchable anisotropic conductive film is less than 10 wt%, it may be difficult to sufficiently provide a vertical conductivity, and if the amount of the liquid metal exceeds 80 wt%, the stretchable polymer may fail to properly enclose the liquid metal.

In an embodiment, solid particles dispersed in the liquid metal may be further included.

FIG. 1B is a diagram schematically illustrating another example of a stretchable anisotropic conductive film according to an embodiment of the present disclosure.

Referring to FIG. 1B, the stretchable anisotropic conductive film according to an embodiment of the present disclosure includes a patterned stretchable polymer 110, a liquid metal 120, and solid particles 130.

The solid particles 130 may be dispersed on a surface of the liquid metal or dispersed throughout the liquid metal.

The solid particles 130 may at least partially cover a side surface of the liquid metal. Thus, the liquid metal 120 may be prevented from flowing in a liquid state when the stretchable anisotropic conductive film 100 is attached to a predetermined place and then detached.

In an embodiment, the solid particles 130 may further include at least one selected from a group consisting of metal particles, metal oxide particles, and semiconductor oxide particles.

In an embodiment, the metal particles may include at least one selected from a group consisting of copper (Cu), gold (Au), platinum (Pt), silver (Ag), iron (Fe), cobalt (Co), nickel (Ni), aluminum (Al), chromium (Cr), tungsten (W), molybdenum (Mo), and titanium (Ti).

In an embodiment, the solid particles may have a core-shell structure. The core-shell structure may be a core-shell structure in the form of a commercial conductive ball (a polymer-metal (may be multiple layers) in which a thin metal film is deposited on a surface of a PS particle) in addition to a core-shell formed of metal-metal.

In an embodiment, the metal oxide particles or semiconductor oxide particles may include at least one selected from a group consisting of SiO₂, Fe₂O₃, Fe₃O₄, BiVO₄, Bi₂WO₄, TiO₂, SrTiO₃, ZnO, CuO, Cu₂O, NiO, SnO₂, CoO, In₂O₃, WO₃, MgO, CaO, La₂O₃, Nd₂O₃, Y₂O₃, CeO₂, PbO, ZrO₂, Co₃O₄, and Al₂O₃.

Unlike metal particles, the semiconductor oxide particles may change rheology instead of reacting with the liquid metal, thereby exhibiting different characteristics from metal particles.

When solid particles are mixed with the liquid metal at a specific ratio, a behavior of a change to a paste form may be shown.

In an embodiment, a volume ratio of the liquid metal : the solid particles may be in a range of 99 : 1 to 70 : 30; 99 : 1 to 80 : 30; 99 : 1 to 90 : 30; 90 : 1 to 70 : 30; 90 : 1 to 80 : 30; 90 : 1 to 90 : 30; 80 : 1 to 70 : 30; 80 : 1 to 80 : 30; or 70 : 1 to 70 : 30.

If the volume ratio of the liquid metal : the solid particles is less than 70 : 30, an issue of a leakage of the liquid metal due to external stress may occur, and if the volume ratio of the liquid metal : the solid particles exceeds 99 : 1, processing may become difficult and an issue of curing (rigidity, solidification) may occur.

The solid particles may have an average diameter of 50 nanometers (nm) to 5 micrometers (µm); 50 nm to 3 µm; 50 nm to 1 µm; 10 nm to 5 µm; 10 nm to 3 µm; 10 nm to 1 µm; 50 nm to 5 µm; 50 nm to 3 µm; 50 nm to 1 µm; 100 nm to 5 µm; 100 nm to 3 µm; 100 nm to 1 µm; 500 nm to 5 µm; 500 nm to 3 µm; 500 nm to 1 µm; 1 µm to 5 µm; 1 µm to 3 µm; or 3 µm to 5 µm.

If the average diameter of the solid particles is less than 50 nm, an issue of preparing fine particles may occur, and if the average diameter of the solid particles exceeds 5 µm, a size of a pattern and a thickness of a film may be limited.

Desirably, the solid particles may have an average diameter of 50 nm to 3 µm.

In an embodiment, the stretchable polymer may include at least one selected from a group consisting of polydimethylsiloxane (PDMS), styrene-ethylene/butylene-styrene triblock copolymer (SEBS), styrene-ethylene/butylene-styrene-graft-maleic anhydride copolymer (SEBS-g-MA), polyethylene-graft-maleic anhydride (PE-g-MA), polypropylene-graft-maleic anhydride copolymer (SEBS-g-MA), polyethylene-graft-maleic anhydride (PE-g-MA), polypropylene-graft-maleic anhydride (PP-g-MA), polyethylene-graft-acrylic acid (PE-g-AA), poly-propylene-graft-acrylic acid (PP-g-AA), polyurethane (PU), polyethylene terephthalate (PET), polyethylene sulfone (PES), polymethacrylate (PMA), polyethylene naphthalate (PEN), polycarbonate (PC), polymethyl methacrylate (PMMA), polyimide (PI), polypropylene (PP), ethylene vinyl acetate (EVA), amorphous polyethylene terephthalate (APET), polypropylene terephthalate (PPT), polyethylene terephthalate glycerol (PETG), polycyclohexylene dimethylene terephthalate (PCTG), modified triacetyl cellulose (TAC), cyclo olefin polymer (COP), cyclo olefin copolymer (COC), dicyclopentadiene polymer (DCPD), cyclopentadiene polymer (CPD), polyarylate (PAR), polyether imide (PEI), a silicon resin, a fluorine resin, and a modified epoxy resin.

Desirably, the stretchable polymer may be PDMS.

Although only the stretchable polymer 110 and the liquid metal 120 are illustrated in FIGS. 1A and 1B, a layer, for example, a silicon (Si) substrate or a glass substrate, which functions as a support under the stretchable polymer 110, may be further included.

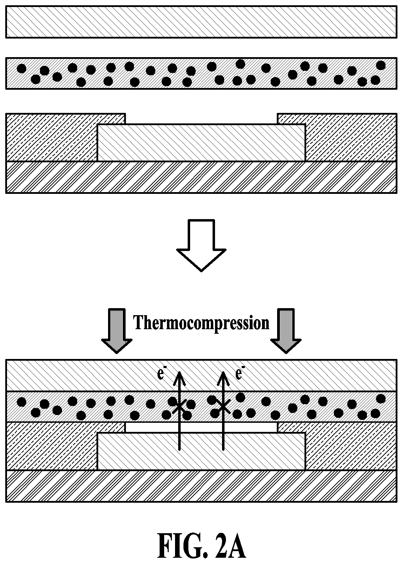

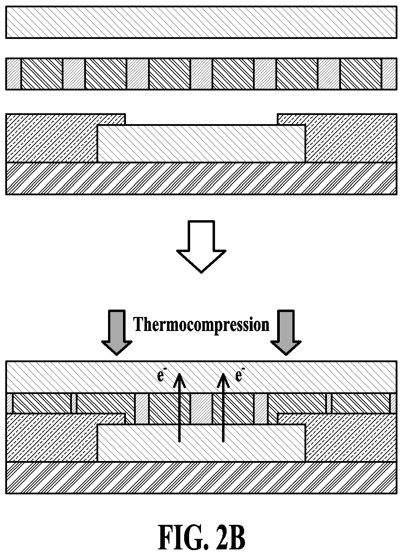

FIG. 2A is a diagram illustrating a transformation of an anisotropic conductive film using solid conductive balls according to a related art, and FIG. 2B is a diagram illustrating a transformation of a stretchable anisotropic conductive film using a liquid metal according to the present disclosure.

As shown in FIG. 2A, it can be found that the anisotropic conductive film according to the related art has a difficulty in conducting current with a concave lower electrode, instead of a protruding lower electrode, due to a limitation in a transformation caused by a thermocompression because the solid conductive balls are used.

As shown in FIG. 2B, it can be found that the stretchable anisotropic conductive film of the present disclosure may be transformed to match a shape of a concave lower electrode, using a stretchable and conductive liquid metal that is in a liquid state at room temperature, instead of using a solid conductive ball, and may provide a high anisotropic conductivity at a metal level (>10⁶ S/m).

A method of manufacturing a stretchable anisotropic conductive film according to another embodiment of the present disclosure includes: a step of patterning a photoresist on a substrate; a step of surface-treating the substrate on which the photoresist is patterned; a step of applying a stretchable polymer onto the surface-treated substrate; a step of thermally curing the applied stretchable polymer; a step of removing the patterned photoresist; a step of removing the substrate; and a step of filling a space formed by removing the photoresist with a liquid metal.

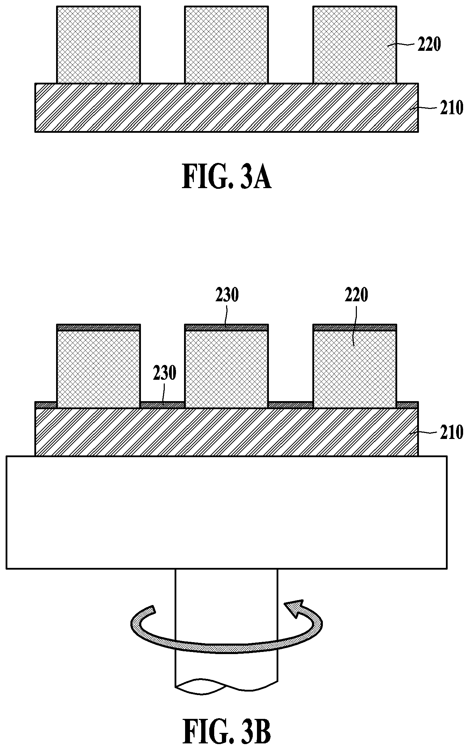

FIGS. 3A to 3G are diagrams illustrating a method of manufacturing a stretchable anisotropic conductive film according to an embodiment of the present disclosure.

Referring to FIG. 3A, first, a substrate 210 is prepared, and a photoresist 220 is patterned on the substrate.

A material and type of the substrate 210 are not limited.

In an embodiment, the substrate may include at least one selected from a group consisting of a flexible substrate, a semiconductor substrate, an insulating substrate, and a stretchable substrate.

The substrate 210 may include, for example, at least one selected from a group consisting of a silicon substrate, a P-doped silicon (P+ doped-Si) substrate, a polyimide substrate, a polydimethylsiloxane (PDMS) substrate, a polyethylene terephthalate (PET) substrate, a glass substrate, and a paper substrate.

Desirably, the substrate 210 may be a silicon substrate.

The patterned photoresist 220 may be formed by a photolithography process-based stamping process using a photoresist.

The photoresist may include at least one selected from a group consisting of SU-8 50, SU-8 2, AZ nLOF 2070, and AZ 5214.

Through the photolithography process-based stamping process, a polymer film with a regular arrangement of a uniform size, spacing, and high resolution may be patterned.

In the case of previously reported anisotropic conductive films (ACFs), complex processes need to be performed multiple times, however, the stamping process allows a mold to be reused, to have advantages of securing a simplicity and mass production of the process and of being applicable to various types of polymers, and thus, extension to a stretchable anisotropic conductive film (S-ACF) with various physical properties may be possible depending on circumstances.

In an embodiment, the surface-treating may be surface-treating the substrate using O₂ plasma, a silane-based material 230, or both.

As illustrated in FIG. 3B, the substrate 210 on which the photoresist 220 is patterned may be surface-treated with the silane-based material 230.

The surface-treating may be performed to easily remove a stretchable polymer.

In an embodiment, the silane-based material may include at least one selected from a group consisting of fluorodecyltrichlorosilane (FDTS), methacryloxypropyltrimethoxysilane (MPTMS), undecenyltrichlorosilane (UTS), vinyl-trichlorosilane (VTS), decyltrichlorosilane (DTS), octadecyltrichlorosilane (OTS), dimethyldichlorosilane (DDMS), dodecenyltrichlorosilane (DDTS), fluoro-tetrahydrooctyltrimethylchlorosilane (FOTS), perfluorooctyldimethylchlorosilane, aminopropylmethoxysilane (APTMS), chlorosilane, fluorosilane, methoxy silane, alkylsilane, and aminosilane.

Desirably, the silane-based material may be octadecyltrichlorosilane (OTS).

For example, after an O₂ plasma treatment is performed on the substrate, a solution containing 2 wt% of n-octadecyltrichlorosilane (OTS) dissolved in toluene may be spin-coated at 3,000 rpm, and the toluene may be dried at a high temperature of 120°C.

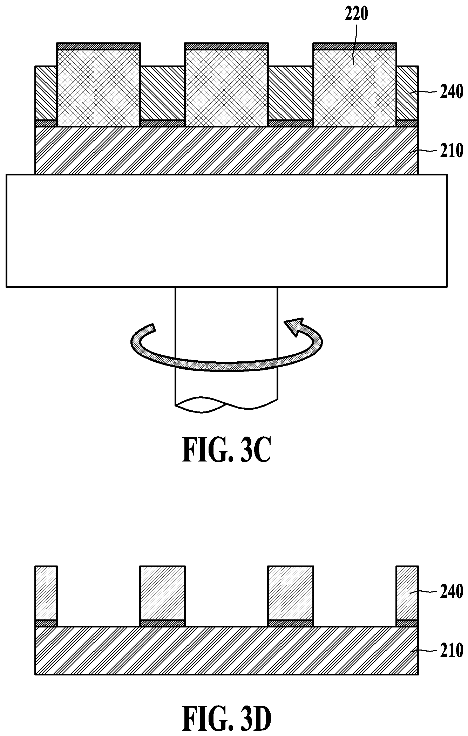

As illustrated in FIG. 3C, a stretchable polymer 240 may be applied onto the substrate 210 that is surface-treated with the silane-based material 230.

In an embodiment, the step of applying the stretchable polymer onto the surface-treated substrate may be performed by at least one method selected from a group consisting of blade printing, screen printing, brush painting, spin coating, dip coating, bar coating, dropping, spray coating, inkjet printing, and spotting.

Desirably, the step of applying the stretchable polymer onto the surface-treated substrate may be performed by spin coating.

In an embodiment, the stretchable polymer may include at least one selected from a group consisting of polydimethylsiloxane (PDMS), styrene-ethylene/butylene-styrene triblock copolymer (SEBS), styrene-ethylene/butylene-styrene-graft-maleic anhydride copolymer (SEBS-g-MA), polyethylene-graft-maleic anhydride (PE-g-MA), polypropylene-graft-maleic anhydride copolymer (SEBS-g-MA), polyethylene-graft-maleic anhydride (PE-g-MA), polypropylene-graft-maleic anhydride (PP-g-MA), polyethylene-graft-acrylic acid (PE-g-AA), poly-propylene-graft-acrylic acid (PP-g-AA), polyurethane (PU), polyethylene terephthalate (PET), polyethylene sulfone (PES), polymethacrylate (PMA), polyethylene naphthalate (PEN), polycarbonate (PC), polymethyl methacrylate (PMMA), polyimide (PI), polypropylene (PP), ethylene vinyl acetate (EVA), amorphous polyethylene terephthalate (APET), polypropylene terephthalate (PPT), polyethylene terephthalate glycerol (PETG), polycyclohexylene dimethylene terephthalate (PCTG), modified triacetyl cellulose (TAC), cyclo olefin polymer (COP), cyclo olefin copolymer (COC), dicyclopentadiene polymer (DCPD), cyclopentadiene polymer (CPD), polyarylate (PAR), polyether imide (PEI), a silicon resin, a fluorine resin, and a modified epoxy resin.

Desirably, the stretchable polymer may be PDMS.

The stretchable polymer may be applied in a thickness less than that of a photoresist pattern.

Subsequently, thermal curing may be performed on the applied stretchable polymer.

In an embodiment, the step of thermally curing the applied stretchable polymer may be performed at a temperature range of 50°C to 100°C; 50°C to 80°C; 50°C to 60°C; 70°C to 100°C; 70°C to 80°C; or 80°C to 100°C for 5 minutes to 60 minutes; 5 minutes to 60 minutes.

As illustrated in FIG. 3D, the photoresist may be removed.

Thus, a patterned polymer film with a hole having a shape opposite to that of the photoresist pattern may be obtained.

An anisotropic conductive film with various shapes may be quickly and easily manufactured by adjusting the size and depth of the pattern.

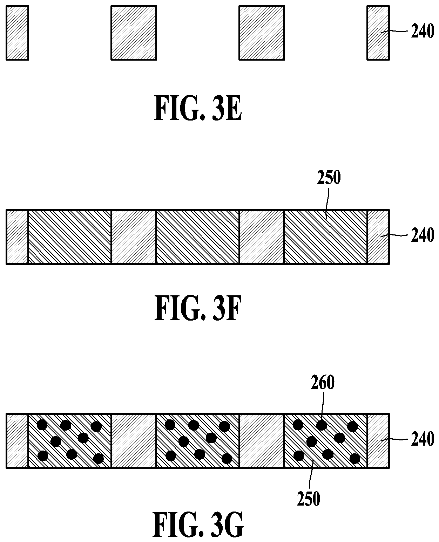

As illustrated in FIG. 3E, the substrate may be removed.

Since the O₂ plasma treatment and the surface-treating with the silane-based material are performed on the substrate, it is easy to separate the substrate and the polymer.

As illustrated in FIG. 3F, a space formed by removing the photoresist may be filled with a liquid metal 250.

In an embodiment, the liquid metal 250 may remain in a liquid state at room temperature, and accordingly a shape thereof may be changed. Due to a surface tension and an interfacial tension between the liquid metal 250 and the stretchable polymer 240, the liquid metal 250 may have a predetermined shape.

In an embodiment, by the liquid metal 250, current may anisotropically, that is, vertically pass through the anisotropic conductive film.

In an embodiment, the liquid metal may include at least one selected from a group consisting of gallium (Ga), indium (In), tin (Sn), mercury (Hg), lead (Pb), bismuth (Bi), cadmium (Cd), an eutectic gallium-indium alloy (EGaIn), an eutectic gallium-indium-tin alloy (Galinstan), gallium-indium (Ga/In), gallium/lead (Ga/Pb), gallium/cadmium (Ga/Cd), gallium/zinc (Ga/Zn), gallium/tin (Ga/Sn), gallium/bismuth (Ga/Bi), gallium/thallium (Ga/Tl), tin/silver (Sn/Ag), tin/gold (Sn/Au), tin/copper (Sn/Cu), tin/nickel (Sn/Ni), lead/antimony (Pb/Sb), lead/gold (Pb/Au), and lead/cadmium (Pb/Cd).

Desirably, the liquid metal may include gallium (Ga).

In an embodiment, the step of filling the space formed by removing the photoresist with the liquid metal may be performed by at least one method selected from a group consisting of blade printing, screen printing, brush painting, spin coating, dip coating, bar coating, dropping, spray coating, inkjet printing, and spotting.

Desirably, the coating may be performed by blade printing. The blade printing differs from screen printing in that dual blades including liquid metals are spaced apart by tens to hundreds of µm from a substrate. Unlike inkjet printing, in which pressure is applied, pressure is not applied.

In a liquid metal printing method, a liquid metal included in a printer blade is brought into contact with a polymer film with a hole patterned in advance, and then moved at a predetermined speed. The liquid metal wets and enters the hole to fill the hole, thereby allowing current to vertically pass through the polymer film, and a portion of the polymer film in which a hole is absent does not have a conductivity in the horizontal direction, because the liquid metal does not remain due to non-wettability of the liquid metal.

Through the above blade printing process, by a simple method, a liquid metal may be printed on a patterned polymer to induce non-wettability, and the liquid metal may be selectively printed on the patterned portion only. The liquid metal may be patterned to have an anisotropic conductivity that provides a conductivity in the vertical direction only. This overcomes a limitation of a difficulty in patterning a liquid metal due to a high surface tension, through a surface oxide film and fluid dynamics analysis.

In the case of an ACF using a rubbing process according to the related art, a process was complex and it was also difficult to evenly fill all patterns with conductive particles, however, a process simplicity and uniformity may be secured based on a printing process of filling only a specific area with a liquid metal using a wettability of the liquid metal.

In addition, although a large number of elements were required for a larger area in the related art, it is easy to increase an area using a simple method of adjusting a size of a printer head.

By a simple printing process at room temperature, it is easy to secure an economic feasibility in comparison to conventional methods that require a large number of high-temperature processes.

Therefore, the liquid metal printing process is a process with process simplification, uniformity, large-area expansion, and economic feasibility.

When a liquid metal is converted into particles and when multiple particles are in contact with each other due to an oxide film formed on surfaces of the particles, an insulation state may be achieved, and accordingly an additional process, such as microwave irradiation, is required to provide a conductivity between the particles, however, a corresponding printing scheme does not require such a process because the conductivity in the vertical direction is provided in the form of a liquid metal bulk, instead of liquid metal particles.

A porous region is filled with a liquid metal to provide a vertical conductivity, and a non-conductive oxide film with a thickness of 3 nm is formed in a non-porous polymer region, and accordingly an issue of crosstalk in which electricity flows in the horizontal direction does not occur.

In an embodiment, after the step of filling the space formed by removing the photoresist with the liquid metal, a step of adding solid particles to the liquid metal may be further included.

As illustrated in FIG. 3G, solid particles 260 may be added to the liquid metal 250.

The solid particles 260 may be dispersed on the surface of the liquid metal 250 or dispersed throughout the liquid metal 250, to form an alloy. After the alloy is formed, solid particle residues may be removed.

The solid particles 260 may at least partially cover a side surface of the liquid metal 250. Thus, the liquid metal 250 may be prevented from flowing in a liquid state when the stretchable anisotropic conductive film is attached to a predetermined place and then detached.

In an embodiment, the solid particles 260 may further include at least one selected from a group consisting of metal particles, metal oxide particles, and semiconductor oxide particles.

In an embodiment, the solid particles may have a core-shell structure, and may be a core-shell structure in the form of a commercial conductive ball (a polymer-metal (may be multiple layers) in which a thin metal film is deposited on a surface of a PS particle) in addition to a core-shell formed of metal-metal.

In an embodiment, the metal particles may include at least one selected from a group consisting of copper (Cu), gold (Au), platinum (Pt), silver (Ag), iron (Fe), cobalt (Co), nickel (Ni), aluminum (Al), chromium (Cr), tungsten (W), molybdenum (Mo), and titanium (Ti).

Desirably, the metal particles may be iron (Fe) or nickel (Ni).

In an embodiment, the metal oxide particles or semiconductor oxide particles may include at least one selected from a group consisting of SiO₂, Fe₂O₃, Fe₃O₄, BiVO₄, Bi₂WO₄, TiO₂, SrTiO₃, ZnO, CuO, Cu₂O, NiO, SnO₂, CoO, In₂O₃, WO₃, MgO, CaO, La₂O₃, Nd₂O₃, Y₂O₃, CeO₂, PbO, ZrO₂, Co₃O₄, and Al₂O₃.

Desirably, the metal oxide particles or semiconductor oxide particles may be Fe₂O₃.

When solid particles are mixed with the liquid metal at a specific ratio, a behavior of a change to a paste form may be shown. When an alloy is formed at a composition ratio with physical properties of a paste, a stability and a high conductivity may be maintained during stretching of a stretchable anisotropic conductive film.

A stretchable electronic device according to another embodiment of the present disclosure includes the stretchable anisotropic conductive film according to an embodiment of the present disclosure or a stretchable anisotropic conductive film manufactured by the method of manufacturing the stretchable anisotropic conductive film according to another embodiment of the present disclosure.

In an embodiment, the stretchable electronic device may include at least one selected from a group consisting of a flexible display, a stretchable display, a semiconductor test socket, a sensor, and an electronic skin.

Since a laminated structure of a flexible display and a stretchable display forms a vertical bond through the stretchable anisotropic conductive film, five or six layers of the stretchable anisotropic conductive film may be included for each display on average.

With the development of materials and process technology, a size of an electronic device, a circuit, and a wiring are becoming miniaturized and a mechanical flexibility and deformability are required, and thus, the stretchable anisotropic conductive film of the present disclosure with a highly regular arrangement is essential for an electrical connection between increasingly fine electronic devices and circuits.

A semiconductor test socket, similarly to a stretchable anisotropic conductive film, requires an anisotropic conductivity. Recently, an application range of silicon rubber sockets is expanding to a high value-added system semiconductor market, such as central processing units (CPUs) and graphics processing units (GPUs), and accordingly, a technology for fine pitches having various sizes and shapes and enabling large-area expansion, high-flexibility, and low-pressure contact is required. Since a pogo pin and a silicon rubber socket method according to the related art have a difficulty in simultaneously ensuring high flexibility/uniform contact/high conductivity, a test socket for larger area/high flexibility/high conductivity/high density is required to solve the above difficulty, and a stretchable anisotropic conductive film according to an embodiment of the present disclosure may be used.

Hereinafter, the present disclosure will be described in detail with reference to the following example and comparative example. However, the technical idea of the present disclosure is not limited or restricted thereby.

### [Example]

A SU-8 50 photoresist was spin-coated on a silicon substrate to a height of 40 µm (3,000 rpm, 30 seconds) and then soft baked on a hot plate at 65°C for 5 minutes and at 95°C for 15 minutes consecutively.

Subsequently, the SU-8 50 photoresist was exposed at 250 mJ/cm² using a UV lamp and a photomask to open a space in which a polymer is to be formed, and then a substrate on which the photoresist was patterned was post-exposure baked (PEB) on a hot plate at 65°C for 1 minute and at 95°C for 4 minutes consecutively.

Subsequently, developing was performed with a SU-8 developer for 6 minutes, rinsing with isopropyl alcohol (IPA) was performed, and drying with N₂ gas was performed. Subsequently, a photolithography process was completed with a curing step of performing hard baking on a hot plate at 150°C for 30 minutes.

On the substrate, a photoresist was patterned into a shape of a square pillar with a width of 20 µm, a length of 20 µm, and a height of 40 µm.

Subsequently, after an O₂ plasma treatment was performed on the silicon substrate with the photoresist patterned into square pillars, a solution of 2 wt% of n-octadecyltrichlorosilane in toluene was spin-coated at 3,000 rpm, and the toluene was removed at a high temperature of 120°C.

A polymer with a thickness of 1 µm to 10 µm less than that of a photoresist pillar was spin-coated and thermally cured, to obtain a patterned polymer film with a hole having a shape opposite to that of a photoresist pattern.

The polymer film was removed from the substrate, to obtain a patterned polymer film.

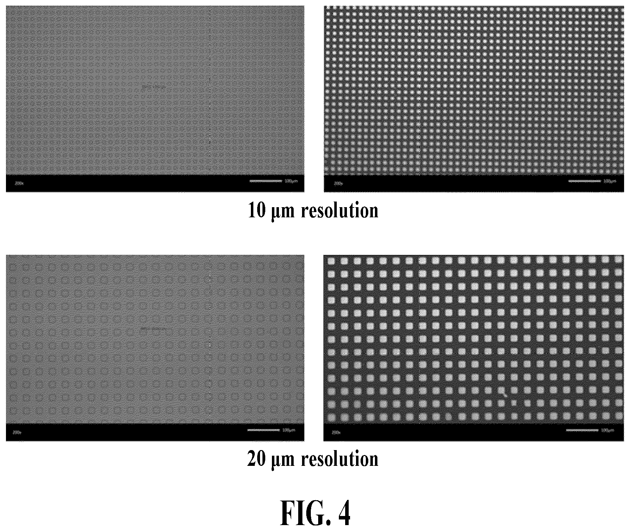

FIG. 4 illustrates images of a patterned surface of a polymer film through a photolithography process-based stamping process.

Referring to FIG. 4, a left image represents a patterned surface of a polymer film, and a right image represents the surface filled with a liquid metal after a liquid metal printing. It can be found that the polymer film is patterned with a regular arrangement of a uniform size, spacing, and a high resolution at 10 µm resolution and 20 µm resolution.

The patterned polymer film was placed on a printing substrate, and a liquid metal was printed in a shape of a square with a side length of 20 µm, to manufacture a stretchable anisotropic conductive film.

While the embodiments are described with reference to drawings, it will be apparent to one of ordinary skill in the art that various alterations and modifications in form and details may be made in these embodiments without departing from the spirit and scope of the claims and their equivalents. For example, suitable results may be achieved if the described techniques are performed in a different order and/or if components in a described system, architecture, device, or circuit are combined in a different manner and/or replaced or supplemented by other components or their equivalents.

Therefore, other implementations, other embodiments, and equivalents to the claims are also within the scope of the following claims.

## Claims

1. A stretchable anisotropic conductive film comprising:
a patterned stretchable polymer; and
a liquid metal filled in a patterned portion of the stretchable polymer.

2. The stretchable anisotropic conductive film of claim 1, wherein the liquid metal is configured to allow current to pass through both sides of the anisotropic conductive film.

3. The stretchable anisotropic conductive film of claim 1, wherein the liquid metal comprises at least one selected from a group consisting of gallium (Ga), indium (In), tin (Sn), mercury (Hg), lead (Pb), bismuth (Bi), cadmium (Cd), an eutectic gallium-indium alloy (EGaIn), an eutectic gallium-indium-tin alloy (Galinstan), gallium-indium (Ga/In), gallium/lead (Ga/Pb), gallium/cadmium (Ga/Cd), gallium/zinc (Ga/Zn), gallium/tin (Ga/Sn), gallium/bismuth (Ga/Bi), gallium/thallium (Ga/Tl), tin/silver (Sn/Ag), tin/gold (Sn/Au), tin/copper (Sn/Cu), tin/nickel (Sn/Ni), lead/antimony (Pb/Sb), lead/gold (Pb/Au), and lead/cadmium (Pb/Cd).

4. The stretchable anisotropic conductive film of claim 1, wherein the liquid metal is in an amount of 10% by weight (wt%) to 80 wt% in the stretchable anisotropic conductive film.

5. The stretchable anisotropic conductive film of claim 1, further comprising:
solid particles dispersed in the liquid metal,
wherein the solid particles further comprise at least one selected from a group consisting of metal particles, metal oxide particles, and semiconductor oxide particles,
wherein the solid particles have a core-shell structure,
wherein the metal particles comprise at least one selected from a group consisting of copper (Cu), gold (Au), platinum (Pt), silver (Ag), iron (Fe), cobalt (Co), nickel (Ni), aluminum (Al), chromium (Cr), tungsten (W), molybdenum (Mo), and titanium (Ti), and
wherein the metal oxide particles, or semiconductor oxide particles comprise at least one selected from a group consisting of SiO₂, Fe₂O₃, Fe₃O₄, BiVO₄, Bi₂WO₄, TiO₂, SrTiO₃, ZnO, CuO, Cu₂O, NiO, SnO₂, CoO, In₂O₃, WO₃, MgO, CaO, La₂O₃, Nd₂O₃, Y₂O₃, CeO₂, PbO, ZrO₂, Co₃O₄, and Al₂O₃.

6. The stretchable anisotropic conductive film of claim 5, wherein a volume ratio of the liquid metal : the solid particles is in a range of 99 : 1 to 70 : 30.

7. The stretchable anisotropic conductive film of claim 1, wherein the stretchable polymer comprises at least one selected from a group consisting of polydimethylsiloxane (PDMS), styrene-ethylene/butylene-styrene triblock copolymer (SEBS), styrene-ethylene/butylene-styrene-graft-maleic anhydride copolymer (SEBS-g-MA), polyethylene-graft-maleic anhydride (PE-g-MA), polypropylene-graft-maleic anhydride copolymer (SEBS-g-MA), polyethylene-graft-maleic anhydride (PE-g-MA), polypropylene-graft-maleic anhydride (PP-g-MA), polyethylene-graft-acrylic acid (PE-g-AA), poly-propylene-graft-acrylic acid (PP-g-AA), polyurethane (PU), polyethylene terephthalate (PET), polyethylene sulfone (PES), polymethacrylate (PMA), polyethylene naphthalate (PEN), polycarbonate (PC), polymethyl methacrylate (PMMA), polyimide (PI), polypropylene (PP), ethylene vinyl acetate (EVA), amorphous polyethylene terephthalate (APET), polypropylene terephthalate (PPT), polyethylene terephthalate glycerol (PETG), polycyclohexylene dimethylene terephthalate (PCTG), modified triacetyl cellulose (TAC), cyclo olefin polymer (COP), cyclo olefin copolymer (COC), dicyclopentadiene polymer (DCPD), cyclopentadiene polymer (CPD), polyarylate (PAR), polyether imide (PEI), a silicon resin, a fluorine resin, and a modified epoxy resin.

8. A method of manufacturing a stretchable anisotropic conductive film, the method comprising:
a step of patterning a photoresist on a substrate;
a step of surface-treating the substrate on which the photoresist is patterned;
a step of applying a stretchable polymer onto the surface-treated substrate;
a step of thermally curing the applied stretchable polymer;
a step of removing the patterned photoresist;
a step of removing the substrate; and
a step of filling a space formed by removing the photoresist with a liquid metal.

9. The method of claim 8, wherein
the surface-treating is surface-treating the substrate using O₂ plasma, a silane-based material, or both, and
the silane-based material comprises at least one selected from a group consisting of fluorodecyltrichlorosilane (FDTS), methacryloxypropyltrimethoxysilane (MPTMS), undecenyltrichlorosilane (UTS), vinyl-trichlorosilane (VTS), decyltrichlorosilane (DTS), octadecyltrichlorosilane (OTS), dimethyldichlorosilane (DDMS), dodecenyltrichlorosilane (DDTS), fluoro-tetrahydrooctyltrimethylchlorosilane (FOTS), perfluorooctyldimethylchlorosilane, aminopropylmethoxysilane (APTMS), chlorosilane, fluorosilane, methoxy silane, alkylsilane, and aminosilane.

10. The method of claim 8, further comprising:
after the step of filling the space formed by removing the photoresist with the liquid metal,
a step of adding solid particles to the liquid metal.

11. A stretchable electronic device comprising the stretchable anisotropic conductive film of claim 1 or a stretchable anisotropic conductive film manufactured by the method of claim 8.

12. The stretchable electronic device of claim 11, wherein the stretchable electronic device comprises at least one selected from a group consisting of a flexible display, a stretchable display, a semiconductor test socket, a sensor, and an electronic skin.
